# EUROPEAN PATENT APPLICATION

(11) **EP 4 203 309 A1**
(43) Date of publication of application: **28.06.2023**
(21) Application number: 21217013.8
(22) Date of filing: 22.12.2021
(51) Int. Cl.: H03H 1/00, H03H 7/38, G01R 27/32, G01R 31/28, H03H 9/17

(54) **RESONANCE SPECTROMETER AND METHOD FOR DETERMINING CHARACTERISTICS OF A DEVICE UNDER TEST**

(71) Applicant: Technische Universität Darmstadt, 64289 Darmstadt (DE); Institute Jozef Stefan, 1000 Ljubljana (SI)
(72) Inventor: KOS, Tomaz, 8333 Semic (SI); SLABKI, Mihail, 64295 Darmstadt (DE); KORUZA, Jurij, 8041 Graz (AT); PETROVCIC, Janko, 1372 Hotedrsica (SI)
(74) Representative: LifeTech IP Spies & Behrndt Patentanwälte PartG mbB

(57) **Abstract**

A resonance spectrometer for determining characteristics of a device under test, DUT (5) based on a bias voltage (15) from a direct current, DC, source (10) and an alternating current, AC, signal (25) from an AC-source (20) is disclosed. The spectrometer comprises: a DC output stage (110) for the DC-source (10) configured to provide a high-voltage DC-signal (115); an AC output stage (120) for the AC-source (20) configured to provide a low-voltage AC-signal (125); and a mixing stage (130) configured to combine the high-voltage DC-signal (115) with the low-voltage AC-signal (125) and to provide a combined signal (135) for a resonance measurement to determine the characteristic of the DUT (5).

## Description

The present invention relates to a resonance spectrometer for a device under test (e.g. a piezo-element) and a method for determining characteristics of a device under test and, in particular, to a measurement system for piezoelectric resonance impedance spectroscopy under combined alternating current (AC) and high-voltage direct current (DC) loading.

### BACKGROUND

Piezo-electric components are frequently utilized under high power conditions, where the piezo-element is driven at or near its resonance frequency. Therefore, there is a need for materials for the next generation devices or for an improvement of existing materials to enable a large power generation for conversion.

To tailor or to improve the material properties, a promising strategy is the superposition of a driving AC voltage and an additional DC voltage. By this superposition the piezoelectric and ferroelectric properties are modified. In particular, the efficiency can be increased and the losses can be reduced. However, for the development of materials, testing, and product control there is a need for measurement systems that are able to electromechanically characterize the piezoelectrics and/or the (anti)-ferroelectrics under the combined application of an AC signal with a high DC signal - in particular at high frequencies.

These measurements are carried out with the purpose of determining the impedance spectral properties of these materials under the condition that a DC bias voltage is applied to the material. Conventional testing systems measure electromechanical parameters of piezoelectrics at resonance conditions, either by the impedance resonance method or by transient response methods. The former uses impedance analyzers or so-called LCR meters, while the latter uses a self-built setup. However, none of these conventional measurement systems is able to provide a combination of the following characteristics: a wide frequency range, high DC bias voltage, driving current capability, low output impedance, vibration tracking, protection capabilities for the user or the device and/or sparking protection. In general, the conventional systems are limited with respect to the DC voltages at a fairly low level (well below 500 Volts), a low AC current, a narrow frequency range and a high output impedance.

Therefore, there is a demand for further spectrometers which overcome at least some of the above-mentioned problems of the conventional measurement systems.

### SUMMARY OF THE INVENTION

At least some of the above-mentioned problems are solved by a spectrometer according to claim 1 and a corresponding method according to claim 10. The dependent claims refer to further advantageous realizations for the subject matters of the independent claims.

The present invention relates to a resonance spectrometer for determining a characteristic of a device under test, DUT, based on a bias voltage from a direct current, DC, source and an alternating current, AC, signal from an AC-source. The spectrometer comprises: a DC output stage for the DC-source configured to provide a high-voltage DC-signal, an AC output stage for the AC-source configured to provide a low-voltage AC-signal; and a mixing stage configured to combine the high-voltage DC-signal with the low-voltage AC-signal and to provide a combined signal for a resonance measurement to determine the characteristic of the DUT.

The determined characteristic may, in particular, be an impedance of the DUT as function of the applied frequency, but it may also involve other parameters. The term "low-voltage" and "high-voltage" are relative terms that refer to each other, i.e., the low-voltage has a lower voltage value than the high-voltage. But embodiments may relate to more specific definitions. The device under test (DUT) may be a piezo-element or a sample of a material showing the piezoelectric effect such as piezoelectric and/or piezoceramic and/or antiferroelectric materials which are also sometimes referred to as samples. However, embodiments shall not be limited to particular materials.

Optionally, the spectrometer comprises further at least one of the following:
- a sealed chamber designed to accommodate the DUT in a vacuum or in a protective atmosphere (e.g. to reduce a risk of a dielectric breakdown of air);
- a vibrometer configured to measure (mechanical) vibrations of the DUT when excited by the combined signal (e.g. through a window of the sealed chamber);
- a current measurement unit configured to measure an electric current through the DUT when excited by the combined signal;
- a voltage measurement unit configured to measure a voltage drop over the DUT.

The sealed chamber may include a sample holder in combination with a gas chamber that allows driving the device under test in resonance without rigid boundary conditions and which enables the measurements at low pressures (around or above 1 mbar) up to pressures of more than 2 bar. Moreover, the measured vibrations may include measured amplitudes, a frequency of the vibration, and their behavior in time (e.g. a swing-in behavior). Therefore, the vibrometer may be a laser vibrometer configured to track the mechanical vibrations or the mechanical strain of the DUT during the frequency sweep with high precision.

Optionally, the DC output stage includes at least one of the following:
- a high-voltage, HV, amplifier to provide a voltage (e.g. of at least 500 Volts) based on the bias voltage of the DC-source;
- a low-pass filter configured to filter high frequency noise of the HV amplifier and to output the HV DC-signal;
- a first surge protection element configured to protect at least one circuit component in case of a breakdown (e.g. of the DUT or of air).

The breakdown of the DUT may cause a surge current which could damage unprotected components. The components protected by the first surge protection element may include the DC source, the low-pass filter, the HV amplifier.

Optionally, the AC output stages includes at least one of the following:
- a buffer to provide a low impedance output for the AC output stage;
- a blocking capacitor for protecting the AC source by blocking the DC voltage signals;
- a second surge protection element configured to protect at least one circuit component in case of the breakdown of the DUT.

The circuit components protected by the second surge protection element may include the AC source, the buffer. Otherwise, unprotected circuit components could be damaged by the surge current caused by a possible high-voltage breakdown. The buffer may be an analogue buffer with low output impedance such as an operational amplifier with G=1.

Optionally, at least one of the following components is realized as sacrificial hardware:
- the first surge protection element,
- the second surge protection element,
- the current measurement unit.

Therefore, these elements may act as a fuse and may include one or more resistors, operational amplifiers, diodes, capacitors, ferite beads, gas arrestors, etc. that can be placed on printed circuit board, PCB, or any other support structure with appropriate connectors/terminals. In case of a breakdown (e.g., of the DUT or air), these PCBs can easily be replaced. Therefore, embodiments provide a highspeed overvoltage protection in case of a dielectric breakdown (e.g., of the DUT or air). The sacrificial hardware is designed that, during normal operation, there is no significant influence on the behavior of the DUT.

Optionally, the spectrometer further comprises a data acquisition unit which is configured to acquire measurement values from the current measurement unit and/or the AC signal to enable a frequency dependent impedance measurement on the DUT. The data acquisition unit may include a high pass filter to filter the high-voltage DC signal and to extract the low-voltage AC-signal. The high pass filter may also be a separate component, not being integrated into the data acquisition unit.

Optionally, the spectrometer further comprises a data processing unit configured to receive information from at least one of the following components and may also control them: the AC source, the DC source, the current measurement unit, the data acquisition unit. The data processing unit may thus act as control unit, e.g. to set or to determine DC-voltage, AC-current, AC-voltage, current measurement range and others.

Optionally, the data processing unit is configured to perform at least one of the following functions:
- to perform a calibration and/or a self-test procedure on the spectrometer, e.g. after replacement of one or more of the sacrificial hardware components (e.g. by measuring electric parameter on a DUT with known impedance),
- to switch a polarity for the bias voltage provided by the DC source,
- to perform a frequency sweeping in the low voltage AC signal (e.g. within a range between 10 kHz and 1 MHz),
- to set a predetermined value for at least one of the following: an electric current of the AC signal, a voltage value of the AC signal, a polarity of the high-voltage DC signal, a voltage value of the high-voltage DC signal (the predetermined values may be kept constant during the measurement),
- to reduce a risk of a breakdown of the DUT by turning off the AC source at changes of measurement ranges for an electric current.

Thus, the control unit may keep constant AC voltage or current throughout the frequency sweep, and provides several safety measures for device/DUT/user protection. For this, the data processing unit (control unit) may include installed control software configured to provide one or more of the following: a self-calibration of the system (spectrometer), an automated measurement procedure, a data acquisition and processing, a feedback control for providing a constant AC voltage, or a constant current through an entire measurement cycle accounting also for a nonlinear response of the device under test, and a dielectric breakdown risk reduction procedure. Therefore, a high level of security is achievable without a need of human interaction.

Optionally, the spectrometer further comprises a rate limiter configured to limit a rate for generating the high-voltage DC signal. In particular, when the HV DC signal was turned off (e.g. as protection) the increase of the DC voltage may go with a predetermined or adjustable pace.

Further embodiments relate to a method for determining a characteristic of a DUT based on a bias voltage from a direct current, DC, source and an alternating current, AC, signal from an AC-source. The method comprises:
- generating, by a DC output stage for the DC-source, a high-voltage DC-signal;
- providing, by an AC output stage for the AC-source, a low-voltage AC-signal;
- combining, by a mixing stage, the high-voltage DC-signal with the low-voltage AC-signal; and
- applying the combined signal on the DUT to determine the characteristic.

Optionally, the method comprises further at least one of the following steps:
- setting a frequency of the AC signal;
- measuring an AC voltage drop over the DUT and a current through the DUT;
- setting a constant value for an AC voltage or for an AC current of the low voltage AC signal on the DUT;
- selecting a range for the AC current;
- measuring, in a data acquisition procedure, an AC voltage and/or AC current as function of time or frequency to determine an impedance as characteristic of the DUT.

Optionally, the method comprises further: processing of measured data to determine the impedance of the DUT and/or plotting or saving the measured data or the determined impedance.

This method or at least some steps may also be implemented in software or a computer program product and the order of steps may not be important to achieve the desired effect. Therefore, embodiments of the present invention can, in particular, be implemented by software or as a software module in a control unit or a data processing device. Therefore, embodiment relate also to a computer program product having a program code for performing the method, when the computer program is executed on a processor. Further embodiments relate a computer-readable storage medium comprising instructions which, when executed by a data processing machine, cause the machine to perform the above-defined method or parts thereof.

Embodiments provide the following advantages:
At least some of the above-mentioned problems of conventional systems are overcome by combining several components into a dedicated new measurement setup. The setup is designed to perform the measurements as needed. In particular, the setup includes several safety measures for protecting the device, the samples (DUT), and the users, includes circuits for combining AC- and DC-signals on the DUT, driver with low output impedance, a control system to keep constant AC voltage or current throughout the frequency sweep. Advantageously, embodiments include, inter alia, a self-calibration and/or a self-test procedure, which may utilize reference resistors or equivalent circuits and achieve:
- a broad frequency range up to several hundreds of kHz,
- AC voltage range up to 10 V (for the low-voltage AC signal) with a constant voltage supply at the piezoelectric resonance,
- DC voltage capability of up to 10 kV (for the HV DC signal) with sophisticated safety precautions for users and instruments in case of a breakdown, as well as sparking protection,
- impedance measurement range of several orders of magnitude (1 Ohm to 10 Megaohm).
- low output impedance (e.g. <50 Ohm) and large current capability (e.g. > 100 mA) to avoid a drop in the AC driving voltage on the DUT.
- provides the option to measure mechanical vibrations of the DUT in operation.

### BRIEF DESCRIPTION OF THE DRAWINGS

Various embodiments of the present invention will be described in the following by way of examples only, and with respect to the accompanying drawings, in which:
- Fig. 1: depicts a resonance spectrometer system according to an embodiment of the present invention.
- Fig. 2: illustrates an exemplary measurement setup for the resonance spectrometer according to another embodiment.
- Fig. 3: shows another embodiment of the spectrometer which includes further optional components.
- Fig. 4: shows a schematic flow chart for a method for determining a characteristic of a DUT according the embodiments.
- Fig. 5: shows another flowchart illustrating the steps of an automatic data acquisition procedure that may be implemented by software according to yet another embodiment.
- Fig. 6: shows an exemplary plot of data output of the acquisition procedure according to embodiments.

### DETAILED DESCRIPTION

Various examples will now be described more fully with reference to the accompanying drawings in which some examples are illustrated.

Accordingly, while examples are capable of various modifications and alternative forms, the illustrative examples in the figures will herein be described in detail. It should be understood, however, that there is no intent to limit examples to the particular forms disclosed, but on the contrary, examples are to cover all modifications, equivalents, and alternatives falling within the scope of the disclosure. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing illustrative examples only and is not intended to be limiting. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, steps, operations, elements and/or components, but do not preclude the presence or addition of one or more other features, steps, operations, elements, components and/or groups thereof.

Unless otherwise defined, all terms (including technical and scientific terms) used herein have the same meaning as commonly understood by one of ordinary skill in the art to which examples belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

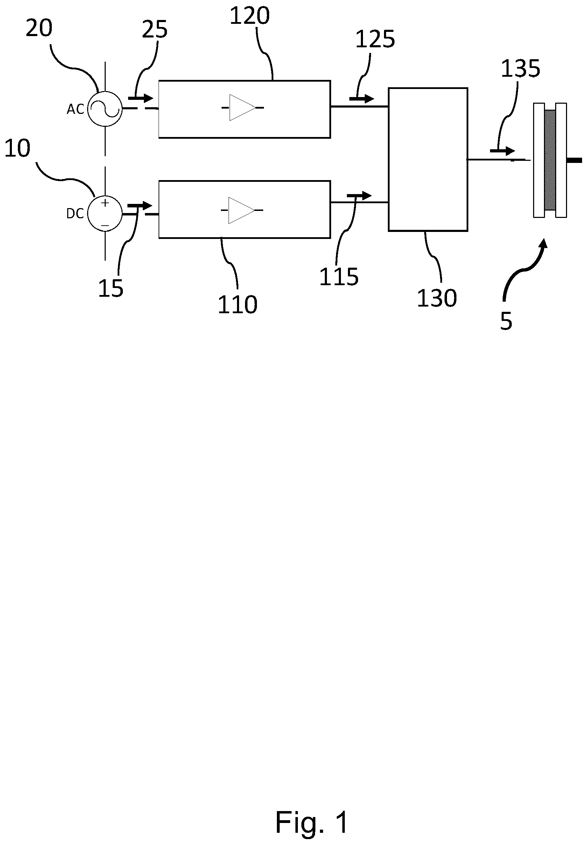

**Fig. 1** shows a resonance spectrometer for determining a characteristic of a DUT 5 (e.g. a piezo-element) based on a bias voltage 15 from a DC-source 10 and an AC signal 25 from an AC-source 20. The spectrometer comprises a DC output stage 110, an AC output stage 120, and a mixing stage 130. The DC output stage 110 is configure to receive the bias voltage from the DC-source 10 and is configured to provide a high-voltage (HV) DC-signal 115. The AC output stage 120 is configured to receive the AC-signal 25 from the AC-source 20 and to provide a low-voltage AC-signal 125. The mixing stage 130 is configured to combine the high-voltage DC-signal 115 with the low-voltage AC-signal 125 and to provide a combined signal 135 for a resonance measurement to determine the characteristic of the DUT 5.

According to further embodiments, the DC-source 10 and/or the AC-source 20 are part of the spectrometer. But the spectrometer may also include merely terminals or connectors to couple to available DC/AC-sources. Likewise, the DUT 5 is general not part of the spectrometer. The spectrometer may, however, include a respective holding mechanism for the DUT 5. The DUT 5 may be any material that shows the piezo-electric effect and the characteristic may be any parameter or function characterizing the DUT 5.

Here and in the following the ground contact is mostly omitted, but it is understood that the voltages are measured relative to ground and all depicted components may couple to a common ground - even though the connection is not depicted.

The above-mentioned problems are solved by combining several components into a dedicated measurement setup. In particular, the spectrometer includes a circuit for combining DC- and AC-signals 115, 125 on the DUT 5. The main problems of the conventional instruments (e.g. the low DC voltage and AC current capability, narrow frequency range and high output impedance) was overcome by using two separate output (amplifier) stages 110, 120 for DC and AC signals 15, 25. For the AC signal 25, the AC output state 120 may provide a low-voltage, high-current, low-gain, wide-band amplifier stage. For the DC signal 15, the DC output state 110 may provide a high-voltage, low-current, high-gain amplifier stage. The resulting signals 115, 125 are then combined and applied to the DUT 5.

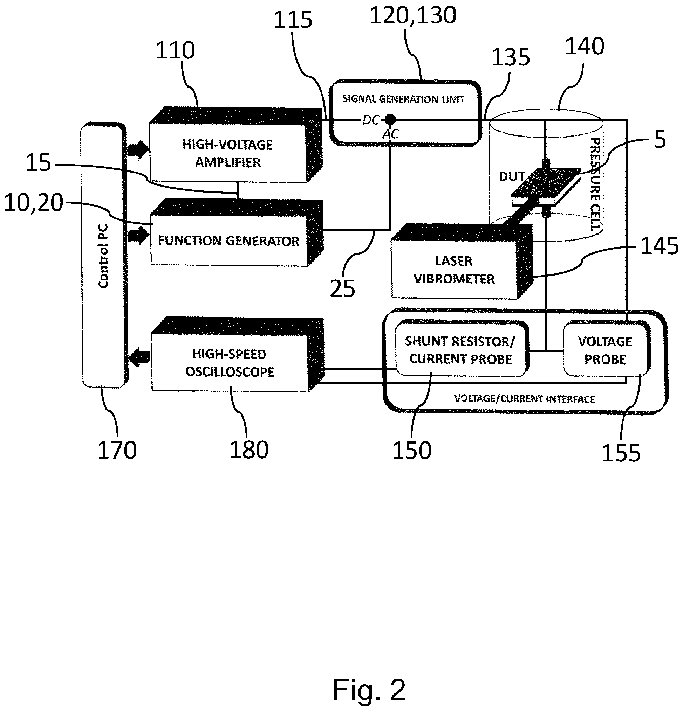

**Fig. 2** illustrates an exemplary measurement setup a resonance spectrometer according to another embodiment. When compared to Fig. 1, in this embodiment, the DC-source 10 and the AC source 20 are integrated in a functional generator 10, 20 generating the bias voltage 15 and the AC signal 25. Moreover, the AC output stage 120 and the combining stage 130 are combined in a signal generation unit 120, 130. Again, the DC output stage 110 includes a HV amplifier to provide the HV DC-signal 115 to the signal generation unit 120, 130. The signal generation unit 120, 130 combines the HV DC-signal 115 with the generated low-voltage AC-signal 125 and applies the result, the combined signal 135, to the DUT 5.

According to this embodiment, a sealed chamber 140 is provided to accommodate the DUT 5 in a predefined environment. Furthermore, a laser vibrometer 145 is provided to measures vibrations of the DUT 5 caused by the combined signal applied to the DUT 5. The sealed chamber 140 may include a window or opening for the laser vibrometer 145. The output of the DUT 5 is fed into a voltage/current interface 150, 155 that includes a current measurement unit 150 (current probe and shunt resistors) and a voltage measurement unit 155 to measure the output current together with a voltage drop over the DUT 5.

According to embodiments the spectrometer may comprise or may couple to (highspeed) oscilloscope 180 and/or a control unit 170. Then, the result of the interface 150, 155 may be provided to the highspeed oscilloscope 180 that provides its output to the control unit 170. The control unit 170 may be configured to control the function generator 10, 20 and the DC output stage 110 (e.g. to adjust the voltages to desired values) and to determine, based on the provided measurement results, the impedance or any other characteristic of the DUT 5 as function of the frequency or voltages (e.g. the applied DC voltage) applied by the signal generation unit 120, 130.

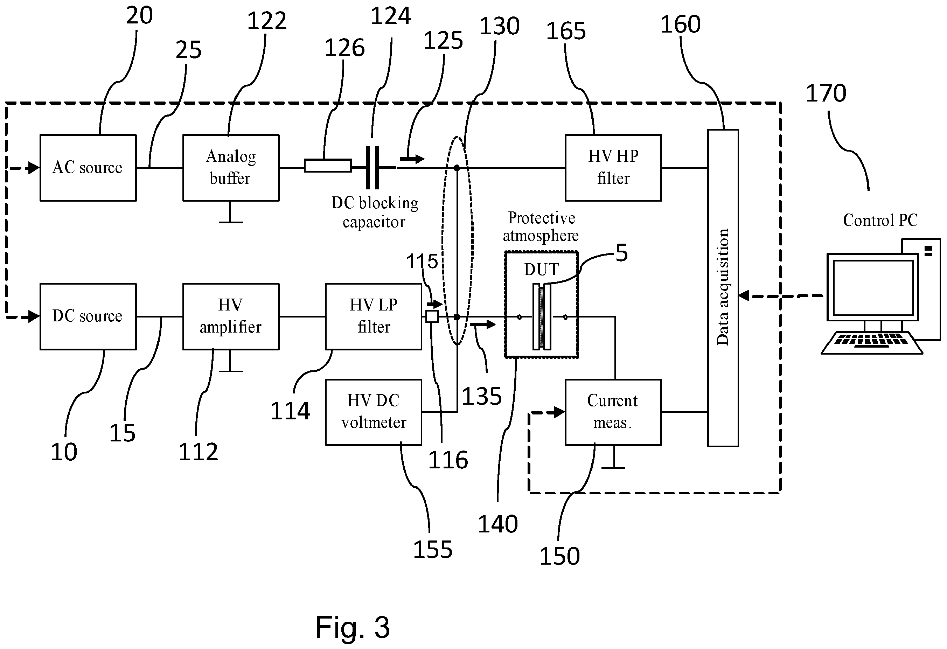

**Fig. 3** shows another embodiment of the spectrometer which includes further optional components. For example, the DC output stage 110 may include a high-voltage amplifier 112, a high-voltage low-pass filter 114, and a first surge protection element 116. The AC output stage 120 may include a buffer 122 (e.g. an analogue buffer), a DC blocking capacitor 124, and second surge protection element 126. The mixing stage 130 is here realized by a simple node connecting the outputs of the DC blocking capacitor 124 and the first surge protection element 116. A high-voltage DC voltmeter 155 couples to this node to measure a voltage value between the mixing stage 130 and the DUT 5. The first and second surge protection elements 116, 126 may act as fuses or other sacrificial hardware to protect the other circuit component (in particular the DC/AC output stages 110,120 and/or the DC/AC sources 10,20).

The spectrometer further includes a data acquisition unit 160 with a high-voltage high-pass filter 165 which is configured to filter the HV DC signal 115 so that the low voltage AC signal 125 is separated and can be acquired by the data acquisition unit 160.

Finally, the spectrometer includes again a control unit 170 which is configured to control one or more of: the data acquisition unit 160, the AC source 20, the DC source 10, and the current measurement unit 150, wherein the controlling may include a setting for at least one of the following values: a bias voltage 15, a polarity of the bias voltage 15, a frequency and/or amplitude for the AC-signal. The control unit 170 may also acquire all measured values from the data acquisition unit 160 and/or may control directly the current measurement unit 150 and/or the voltage measurement unit 155.

The components of the spectrometers as shown in Figs. 1 to 3 may further be characterized as follows:
The DC source 10 together with the DC output stage 110 may be configured to provide an adjustable voltage of up to 10 kV (or at least of 500 V or more than 1 kV). The output voltage 15 of the low-voltage DC source 10 is amplified with the high-voltage (HV) amplifier 112 (e.g. a gain G of up to 500 or up to 1000) designed to provide a high voltage of up to 10 kV. The output voltage of the amplifies 112 is filtered with a HV low-pass (LP) filter (e.g. a passive filter). The integrated HV LP filter 114 may thus filter AC components from the amplification (from the HV amplifier 112) so that noise from the DC output stage 110 cannot interfere with the AC signal 125 from the AC source 20. The filtered voltage is then fed to the DUT 5. An integrated HV DC voltmeter 155 is used for a monitoring of the applied DC-signal 115.

The term "high voltage" may thus refer in embodiments to voltage values of at least 100 V or more than 500 V or within the range between 1 kV to 10 kV.

The DUT 5 is in series connection with the output impedance of the measurement system. Since the DUT 5 impedance in resonance can be as low as a couple of Ohms, an AC voltage drop can be lower than the amplitude of for AC source 20. Therefore, the output impedance of the measurement system is set as low as possible. However, since an output impedance of the AC source may be too high (e.g. 50 Ω or higher) and may thus affect the current capability, the additional buffer 122 (e.g. an operational amplifier with gain equal to 1) is used as an impedance converter to increase a current capability of up to 300 mA (or more) and lowers output impedance, e.g. to 1 Ohm. The frequency range of the buffer may be 50 kHz to 500 kHz (adjusted to the typical range of resonance frequencies).

Thus, the AC source 20 together with the AC output stage 120 can be configured to provide a low output impedance (for example only 2 Ohm or not more than 10 Ohm) for the AC signal 125 with an amplitude of up to exemplary 10 Volts (or up to 5 Volts) and a current capability of up to exemplary 300 mA (or up to 100 mA or up to 500 mA) in a frequency range of 50 kHz to 500 kHz (or between 10 kHz and 2 MHz). This is a typical range of a resonance frequency of a piezoelectric sample material. It is understood that these values may vary and may depend on the particular materials or/and sample geometry. However, according to embodiments, they can be adjusted to drive the spectrometer into a resonance mode of the respective piezoelectric material to perform a resonance impedance analysis.

The term "low voltage" may thus refer to voltage values of at most 100 V or less than 50 V or within the range between 1 mV to 10 V.

The output of the buffer 122 may include or may be protected by the second surge protection element 126 against a dielectric breakdown of the DUT 5. Due to the desired low output impedance, usual surge protection is not effective at high DC voltages as provided by the DC output stage 110. Therefore, the surge protection may be designed as a sacrificial hardware component (e.g. a simple low-cost printed circuit board, PCB) that breaks in the event of HV breakdown of the DUT 5 and can be easily replaced. As a result, also the AC source 20 remains protected. The second surge protection element 126 is designed to not influence a behavior of the DUT 5 during normal operation. In the case of a needed replacement of hardware, the automated calibration procedure may be initiated by the control unit 170 to re-establish the measurement setup.

Furthermore, the blocking capacitor 124 is designed to protect the AC source 20 from high DC voltage in a normal mode of operation (without breakdown of the DUT 5), e.g. by using a high quality (foil) HV capacitor. The blocking capacitor 124 acts as a high-pass filter for the AC-signal 25. The output impedance for the low voltage AC-signal 125 of the measurement system equals the combined impedance of the analogue buffer 122 and capacitor 124. Since the impedance of the blocking capacitor 124 is inversely correlated to its capacitance, embodiments use a high capacitance capacitor (e.g. more than 50 nF or more than 100 nF or multiple thereof).

As already mentioned, for the applied high voltages, there is a risk of a breakdown of air (or of the DUT 5). To prevent this the spectrometer (or a system with the spectrometer) may include a chamber 140 with a holder for the DUT 5. The chamber 140 may be gas chamber to provide protective atmosphere that allows driving the DUT 5 in resonance without rigid boundary conditions and which enables measurements at low pressures (as below as 1 mbar) or overpressure (of up to 2 bar). For example, Sulfur hexafluoride (SF-6) or other gases may be used as insulating gas.

The AC-current through the DUT 5 is measured with the current measurement unit 150, which may incorporate at least four adjustable current ranges (e.g. implemented by three shunt resistors and a current probe). Therefore, the current measurement unit 150 may be configured to measure electric currents over several orders of magnitude from 1 µA up to 0.3 A or even 1 A. This measured current signal is used for the impedance calculation. In addition, the measured current may be monitored to keep an AC current constant through the entire frequency measurement. Thus, only the frequency-dependence may be measured.

A breakdown of the DUT 5 may cause surge current through the shunt resistors and may destroy at least part of the current measurement circuit 150. Therefore, the current measurement unit 150 may be designed as another sacrificial hardware component (e.g. using simple low-cost PCB with the shunt resistors thereon) which can easily be replaced when it is broken. By this, also the data acquisition unit 160 remains protected. Again, the surge protection is designed so that during normal operation no influence on the behavior of the DUT 5 can be measured. As for the other sacrificial components, in the case of a replacement of hardware, an automated calibration procedure may be started.

The data acquisition unit 160 receives various data: the AC voltage applied to the sample, the AC current through the DUT 5 (e.g. AC voltage and current vs time). Optionally, also the applied bias voltage 15 by the DC source 10 and the characteristics of the AC signal 25 may be acquired by the data acquisition unit 160. As mentioned above, the HV HP filter 165 (e.g. an active filter) filters the AC component (the DC component is removed from the signal) which is then used for impedance calculation and for keeping constant the AC voltage through the entire frequency measurement. Optionally, also the measured HV DC voltage 115 may be acquired by the data acquisition unit 160.

The control unit 170 may be data processing system (such as a computer with installed control software). The control unit 170 may be configured to control the components that influence the spectral measurement, e.g. the data acquisition unit 160, current measurement unit 150, the AC source 20, the DC source 10.

According to embodiments, the control unit 170 may be configured to determine at least one parameter (defining the characteristic) of the DUT 5 while keeping the AC driving voltage or AC current constant. In contrast to conventional spectrometer, embodiment can achieve this by having separate or distinguished output stages 110, 120 for AC voltage signal and for the DC voltage signal, whereas in conventional system they are integrated into one unit. In conventional systems instruments with high DC voltage capability have: (i) high output impedance, (ii) a low AC current capability, and (iii) a low-frequency range. Instruments with wide-bandwidth capability, have a low output impedance, but are limited by a low DC voltage capability. As described above, embodiments overcome these limitations. A constant AC voltage/current may also be achieved by dedicated software installed on the control unit 170. Namely, a voltage drop or a current may be checked at every frequency point of the frequency sweep and the AC voltage may be adjusted accordingly.

Finally, according to embodiments, a simultaneous measurement of vibrations of the DUT 5 is facilitated by the provided vibrometer 145 (see Fig. 2), which likewise is used to determine the piezoelectric parameters. For example, the amplitudes of the vibration can be measured as function of the applied frequency. Likewise, an up-swing behavior or an attenuation may be determined. The (laser) vibrometer 145 may also be controlled by the control unit 170 and the data may be acquired by the data acquisition unit 160.

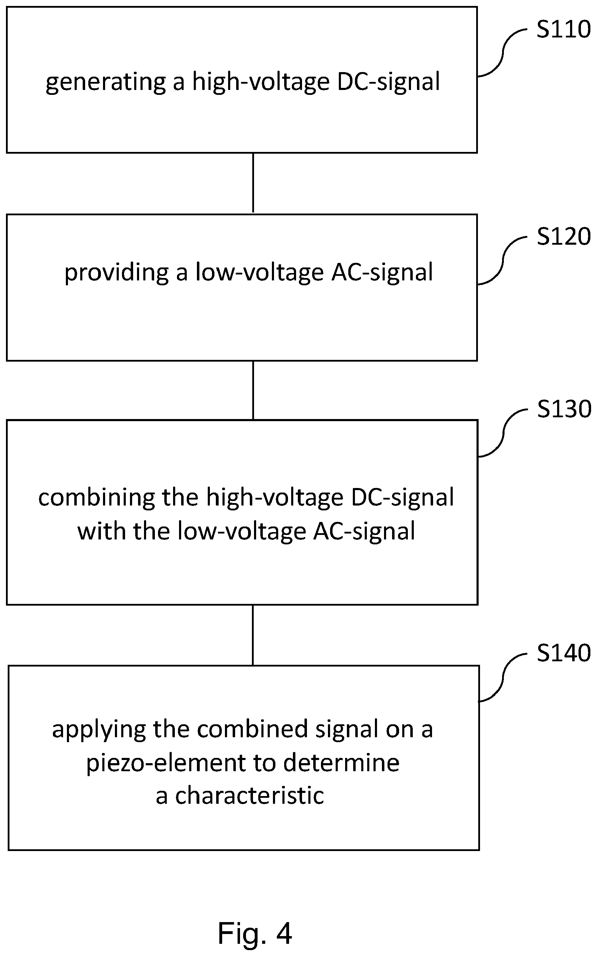

**Fig. 4** shows a schematic flow chart for a method for determining a characteristic of a piezo-element according the embodiments. The determination is based on a bias voltage 15 from a DC source 10 and an AC 25 signal from an AC-source 20. The method comprises the steps:
- generating S110, by a DC output stage 110 for the DC-source 10, a high-voltage DC-signal 115;
- providing S120, by an AC output stage 120 for the AC-source 20, a low-voltage AC-signal 125;
- combining S130, by a mixing stage 130, the high-voltage DC-signal 115 with the low-voltage AC-signal 125; and
- applying S140 the combined signal 135 on the DUT 5 to determine the characteristic.

According to further embodiments, the method may include as further optional steps all functions described before in conjunction with the spectrometer. In particular, the measurement procedure (i.e. the determination of the characteristic) may include one or more of the following steps:
1. Placing the DUT 5 in a holder (the chamber 140), optionally evacuating and/or filling the chamber 140 with a protective atmosphere.
2. Aligning the laser vibrometer 145.
3. Ramping up the DC voltage 115 on the DUT 5 to a set value.
4. Performing a rough frequency sweep and measuring the sample impedance.
5. Adjusting the measurement parameters if needed (e.g., AC voltage 125, current limit, frequency range).
6. Performing a fine frequency sweep and measuring the impedance, particularly around the resonance and/or antiresonance frequencies.
7. Extracting the piezoelectric coefficients from the measurement results.

This method may also be a computer-implemented method. A person of skill in the art would readily recognize that some or all steps of various above-described methods may be performed by programmed computers. Embodiments are also intended to cover program storage devices, e.g., digital data storage media, which are machine or computer readable and encode machine-executable or computer-executable programs of instructions, wherein the instructions perform some or all of the acts of the above-described methods, when executed on the computer or processor.

When installed on the control unit 170 or any other data processing device, the software may control the components of the spectrometer as described before and perform a frequency scan across the user-defined range. By this, data is acquired for a subsequent processing of the measurement results. The software may include or implement at least one of the following:
- an automated measurement procedure,
- data acquisition,
- data processing,
- feedback control for providing a constant AC voltage or current through the entire frequency measurement cycle accounting also for non-linear DUT response,
- a dielectric breakdown risk reduction procedure (e.g. by turning off the AC source 20 at every change of the current measurement range and/or by using rate limiter for applying DC voltage),
- a self-calibration,
- a self-test procedure.

According to embodiments, a user may adjust the measurement parameters (e.g., an AC source amplitude, AC current limit, frequency range) and/or may select a measurement type: constant AC driving voltage or current as needed.

As for measurement procedure, a person skilled in the art knows that the impedance is defined as the ratio of the voltage and the current, which are, in general, complex-valued and vary in time. Therefore, when determining the impedance of the DUT 5 as function of the frequency of the signal passing through the DUT 5, it is of advantage to keep either the voltage or current constant and to measure the other quantity. It is understood that even alternating currents/voltages may have a constant voltage/current value (e.g. defined as a constant energy dissipation in a resistor). Embodiments keep the voltage constant (i.e. the voltage drop over the DUT 5) and vary the frequency of the AC current supplied by the AC-source 20 while measuring the AC current through the DUT 5. This can be done by controlling the AC source 20 (i.e. its frequency and/or its voltage). However, also other ways are possible (e.g. the current is kept constant whereas the voltage is measured) and are covered by further embodiments.

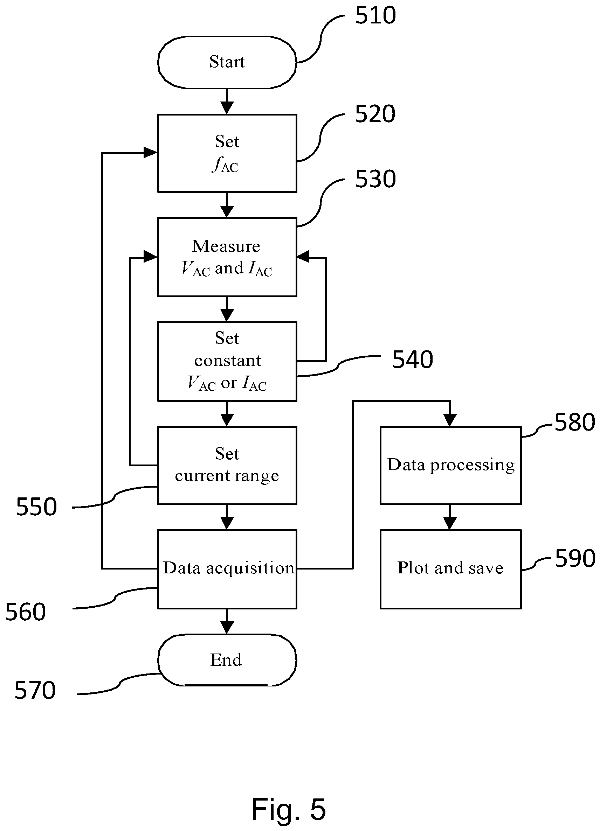

**Fig. 5** show another flowchart illustrating the steps for the data acquisition procedure that may be implemented by software and which may be part of the method according to embodiments.

After starting the frequency loop, at 510, a frequency of the AC source is set, at 520.

At 530, an AC voltage drop on DUT 5 and a current through the DUT 5 is measured. Since the DUT 5 is in series with the output impedance of the analogue buffer 122 and the blocking capacitor 124, and since DUT 5 impedance in resonance can be as low as a couple of Ohms, the AC voltage drop can be lower than set AC source amplitude.

Therefore, at 540, measured values may be used for setting a desired AC voltage drop (V_{AC}) on a DUT 5 or a desired AC current (I_{AC}). This may depend on the user settings. According to embodiments, an optimization algorithm may be incorporated to account for non-linear response from the DUT 5 in resonance. Since this may be done at every frequency point, it is possible to achieve, at 540, a constant AC voltage or current through the entire frequency measurement. Therefore, according to this feedback loop, embodiments do not rely on a fixed voltage or current value set at the AC source 20, which would lead to strong changes of the driving voltage or current on the DUT 5. Instead, the feedback loop implements an automated adjustment to achieve a dynamic stabilization of the set value.

At 550, an appropriate current measurement range is selected. In case of a change of the current measurement range, the optimization of the AC drive parameters (AC voltage drop V_{AC} or the AC current I_{AC}) of the DUT 5 is repeated.

At 560, the data acquisition is performed (measuring the AC voltage and current as function of time). The loop repeats by returning to step 520 until the whole frequency range is measured.

The procedure may end at 570, or an additional loop is used for data processing of the acquired results at 580. The impedance of the DUT 5 maybe calculated with the lock-in detection algorithm. Additionally, so called Continuous Wavelet Transform may be used for a statistical analysis of the acquired data or for calculating error bars of the determined impedance. A person skilled in the art understands, a wavelet continuous transform as a time-frequency analysis method that is useful for analyzing multicomponent signals with oscillating modes, wherein the signal is decomposed into their components.

Finally, at 590, calculated data may be plotted and/or saved into files.

As already mentioned, according to embodiments, the risk of the dielectric breakdown risk can be reduced by turning off the AC source 20 at every change of the current measurement range. After the change, the AC amplitude may be slowly re-applied to the DUT 5.

Furthermore, according to yet another embodiment, the DC voltage is applied to the DUT 5 with a rate limiter (e.g. to increase slowly the DC voltage).

According to yet another embodiment one or more of the following parameters are corrected in accordance to the values acquired during the calibration procedure: a measured AC voltage drop on the DUT 5, the current through the DUT 5, the calculated impedance. The calibration procedure may be repeated every time a sacrificial hardware component is replaced (typically in case of a DUT breakdown).

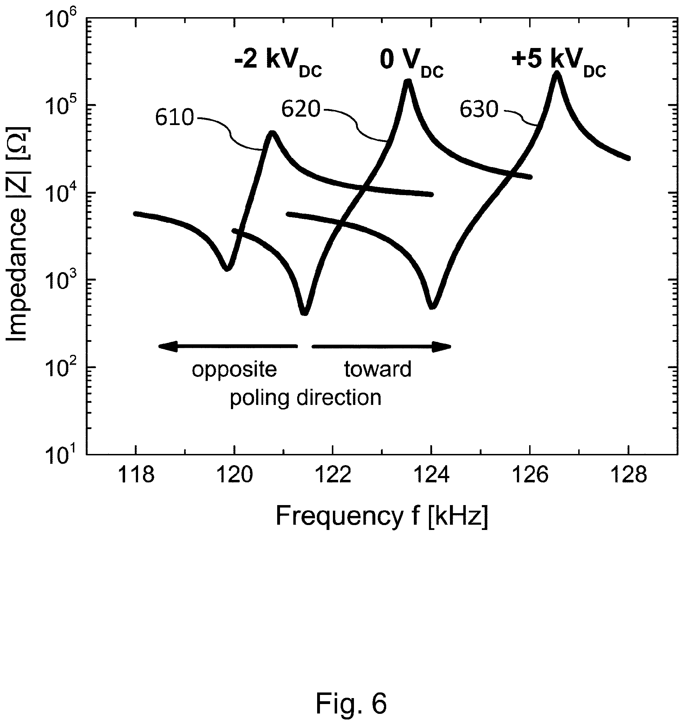

**Fig. 6** shows an exemplary plot as output of the above-described data acquisition procedure. The impedance is shown as function of the frequency and for difference values of the HV DC signal 115. Therefore, according to embodiments, a fine frequency sweep is carried out and the impedance is measured, particularly around the resonance and/or antiresonance frequencies. A first graph 610 shows the impedance around a resonance frequency of about 120 kHz and obtained with HV DC signal of - 2kV, a second graph 620 shows the impedance around a resonance frequency of about 121.6 kHz and is obtained with HV DC signal of o kV (no bias voltage), and a third graph 630 shows the impedance around a resonance frequency of about 124 kHz and obtained with HV DC signal of + 5 kV.

The indicated voltage polarity from the DC voltage source 10 to the DUT 5 correlates to the poling direction.

From the graphs 610, 620, 630 it can be seen that the resonance frequency is shifted to higher values as well as the difference between the minimum and maximum impedance values is increased with an increase in the DC voltage.

The various embodiments provide the following advantages:
The spectrometer according to embodiments can be fully integrated into an experimental system for resonance impedance spectroscopy of ceramic materials using superimposed AC and DC voltage signals 125, 115 with an extended range of adjustable parameters, wherein very high values of the DC voltage 115 can be applied. Most importantly, embodiments enable the characterization of piezoelectric materials at resonance conditions, providing constant AC source voltage or current throughout a frequency sweep (even incorporating compensation for the non-linear behavior of the DUT 5).

In particular, embodiments combine devices and functions (realized by the hardware and software implementation) that allow the application of large DC bias voltages of up to 10 kV during an AC frequency sweep over the resonances of the DUT 5. This can be done without a significant influence on the response of the DUT 5. In addition, embodiments include built-in safety components to protect vital components of the measurement system and the user during the (highly) probable event of dielectric breakdown of unknown samples (DUT 5).

Compared to conventional measurement systems, embodiments are able to provide the desired combination of a wide frequency range, high DC voltage bias, driving current capability, low output impedance, vibration tracking, and user/device/sparking protection capabilities to perform piezoelectric resonance impedance spectroscopy.

Embodiments overcome specific limitations of at least some conventional measurement systems. These include, inter alia, limitations related to relatively low DC voltages. Conventional setups that are capable of measuring frequencies above 10 kHz are limited to DC voltages of up to 200 V (wide-bandwidth amplifiers are limited to low voltages). Embodiments overcome this by separate output stages 110, 120 for both voltage signals (DC and AC). Some conventional impedance analyzers and LCR meters provide expanding measurements with DC voltages, but at the cost of having an inadequate protection of instruments against the dielectric breakdown, added external DC voltage is limited to relatively low values (e.g., 500 V).

Another limitation relates to relatively low AC current and frequency ranges. Conventional DC-extensions to DC voltages of up to 2.000 V are limited by a very narrow frequency range (<10 kHz) and low current capability (<2.7 mA). However, a low current capability leads to a drop of the AC driving voltage in the DUT's low-Ω range. This prohibits the constant voltage/current measurement condition required by the measurement standard.

Yet another limitation that is overcome by embodiments relates to the relatively high output impedance. The output impedance of the conventional systems is > 50 Ω or up to 750 Ω. This leads to a significant drop in AC driving voltage in the DUT's low-Ω range. This, likewise, prohibits the constant voltage/current measurement condition required by the measurement standard.

As a result, embodiments can improve significantly a high-power performance of ceramic materials by the application of DC bias fields (DC signal 115). One example are piezoelectric high-power devices. Conventional high-power devices (resonance power converters) rely predominantly on Pb-containing piezoelectrics with a limited power output capability. Embodiments provide thus promising strategies to increase the power output of Pb-free piezoelectric converters and to outperform the Pb-containing ones. Embodiments allow to probe and to determine the properties of the piezoelectric materials as well as piezoelectric devices, and to get an insight into the fundamental physical mechanisms in the materials under such extended driving conditions. Moreover, embodiments can be used to investigate the piezo-electric properties of other materials, e.g. antiferroelectrics.

The description and drawings merely illustrate the principles of the disclosure. It will thus be appreciated that those skilled in the art will be able to devise various arrangements that, although not explicitly described or shown herein, embody the principles of the disclosure and are included within its scope.

Furthermore, while each embodiment may stand on its own as a separate example, it is to be noted that in other embodiments the defined features can be combined differently, i.e. a particular feature descripted in one embodiment may also be realized in other embodiments. Such combinations are covered by the disclosure herein unless it is stated that a specific combination is not intended.

Although the invention has been illustrated and described in detail by way of preferred embodiments, the invention is not limited by the examples disclosed, and other variations can be derived from these by the person skilled in the art without leaving the scope of the invention. It is therefore clear that there is a plurality of possible variations. It is also clear that embodiments stated by way of example are only really examples that are not to be seen as limiting the scope, application possibilities or configuration of the invention in any way. In fact, the preceding description and the description of the figures enable the person skilled in the art to implement the exemplary embodiments in concrete manner, wherein, with the knowledge of the disclosed inventive concept, the person skilled in the art is able to undertake various changes, for example, with regard to the functioning or arrangement of individual elements stated in an exemplary embodiment without leaving the scope of the invention, which is defined by the claims and their legal equivalents, such as further explanations in the description.

### List of reference signs

- 5: device under test/piezo-element/sample
- 10: direct current source (DC-source)
- 15: bias voltage
- 20: alternating current source (AC-source)
- 25: alternating current signal (AC-signal)
- 110: DC output stage
- 112: high-voltage, HV, amplifier
- 114: low-pass filter
- 115: high-voltage DC-signal (HV DC signal)
- 116: first surge protection element
- 120: AC output stage
- 122: buffer
- 124: blocking capacitor
- 125: low-voltage AC-signal
- 126: second surge protection element
- 130: mixing stage
- 135: combined signal
- 140: sealed chamber
- 145: (laser) vibrometer
- 150: current measurement unit
- 155: voltage measurement unit
- 160: data acquisition unit
- 165: high pass filter
- 170: control unit / data processing unit

## Claims

1. A resonance spectrometer for determining characteristics of a device under test, DUT (5), based on a bias voltage (15) from a direct current, DC, source (10) and an alternating current, AC, signal (25) from an AC-source (20), the spectrometer comprising:
a DC output stage (110) for the DC-source (10) configured to provide a high-voltage DC-signal (115);
an AC output stage (120) for the AC-source (20) configured to provide a low-voltage AC-signal (125); and
a mixing stage (130) configured to combine the high-voltage DC-signal (115) with the low-voltage AC-signal (125) and to provide a combined signal (135) for a resonance measurement to determine the characteristic of the DUT (5).

2. The spectrometer according to claim 1, further comprising at least one of the following:
a sealed chamber (140) designed to accommodate the DUT (5) in a vacuum or in a protective atmosphere;
a vibrometer (145) configured to measure vibrations of the DUT (5) when excited by the combined signal (135);
a current measurement unit (150) configured to measure an electric current through the DUT (5) when excited by the combined signal (135);
a voltage measurement unit (155) configured to measure a voltage drop over the DUT (5).

3. The spectrometer according to claim 1 or claim 2, wherein the DC output stage (110) includes at least one of the following:
a high-voltage, HV, amplifier (112) to provide a voltage of at least 500 Volts based on the bias voltage (15) of the DC-source (10);
a low-pass filter (114) configured to filter high frequency noise of the HV amplifier (112) and to output the HV DC-signal (115);
a first surge protection element (116) configured to protect at least one circuit component in case of a breakdown of the DUT (5).

4. The spectrometer according to one of claims 1 to 3, wherein the AC output stage (120) includes at least one of the following:
a buffer (122) to provide a low impedance output for the AC output stage (120);
a blocking capacitor (124) for protecting the AC source (20) by blocking the DC voltage signals (115);
a second surge protection element (126) configured to protect at least one circuit component in case of the breakdown of the DUT (5).

5. The spectrometer according to one of claims 2 to 4, wherein at least one of the following components is realized as sacrificial hardware:
the first surge protection element (116),
the second surge protection element (126),
the current measurement unit (150).

6. The spectrometer according to one of claims 2 to 5, further comprising:
a data acquisition unit (160) configured to acquire measurement values from the current measurement unit (150) and the AC signal (125) to enable a frequency dependent impedance measurement of the DUT (5),
the data acquisition unit (160) optionally including a high pass filter (165) to filter the high-voltage DC signal (115) to extract the low-voltage AC-signal (125).

7. The spectrometer according to claim 6, further comprising a data processing unit (170) configured to receive information from or to control at least one of the following components:
the AC source (20),
the DC source (10),
the current measurement unit (150),
the voltage measurement unit (155),
the data acquisition unit (160).

8. The spectrometer according to one of claims 5 to 7, wherein the data processing unit (170) is configured to perform at least one of the following functions:
to perform a calibration and/or a self-test procedure on the spectrometer after replacement of one or more of the sacrificial hardware components,
to switch a polarity for the bias voltage provided by the DC source (10),
to perform a frequency sweeping in the low voltage AC signal (125) within a range between 10 kHz and 1 MHz,
to set a predetermined value for at least one of the following: an electric current of the AC signal (125), a voltage value of the AC signal (125), a voltage value of the high-voltage DC signal (115),
to reduce a risk of a breakdown of the DUT (5) by turning off the AC source (20) at changes of measurement ranges for an electric current.

9. The spectrometer according to one of claims 5 to 8, further comprising a rate limiter configured to limit a rate for generating the high-voltage DC signal (115).

10. A method for determining characteristics of a DUT (5) based on a bias voltage (15) from a direct current, DC, source (10) and an alternating current, AC, signal (25) from an AC-source (20), the method comprising:
generating (S110), by a first output amplifier stage (110) for the DC-source (10), a high-voltage DC-signal (115);
providing (S120), by a second output amplifier stage (120) for the AC-source (20), a low-voltage AC-signal (125);
combining (S130), by a mixing stage (130), the high-voltage DC-signal (115) with the low-voltage AC-signal (125); and
applying (S140) the combined signal (135) on the DUT (5) to determine the characteristic.

11. The method of claim 10, further comprising at least one of the following steps:
setting (520) a frequency of the AC signal (25);
measuring (530) an AC voltage drop over the DUT (5) and a current through the DUT (5);
setting (540) a constant value for an AC voltage (V_{AC}) or an AC current (I_{AC}) of the low voltage AC signal (125) on the DUT (5);
selecting (550) a range for the AC current (I_{AC});
measuring (560), in a data acquisition procedure, an AC voltage and AC current as function of time to determine an impedance as characteristic of the DUT (5).

12. The method of claim 11, wherein
the steps of measuring (530) and setting (540) a constant value are repeated until changes for the set values are below a predetermined threshold,
upon a change in set previously set current range, the steps of measuring (530), setting (540), and selecting (550) are repeated,
all steps are repeated for a different set frequency in step 520.

13. The method of claim 11 or claim 12, further comprising:
processing (580) of measured data to determine an impedance of the DUT (5);
plotting or saving (590) the measured data or the determined impedance.

14. A computer-readable storage medium comprising instructions which, when executed by a data processing machine, cause the machine to perform the method of any of claims 10 to 13.
